# EUROPÄISCHE PATENTANMELDUNG

(11) **EP 0 562 224 A1**
(43) Veröffentlichungstag der Anmeldung: **29.09.1993**
(21) Anmeldenummer: 93100107.7
(22) Anmeldetag: 07.01.1993
(51) Int. Cl.: H01L 21/607, H01L 21/603

(54) **Kontaktierungssystem für Halbleiter-Drahtverbindungen**

(30) Priorität: 26.03.1992 CH 969/92
(71) Anmelder: ESEC SA, CH-6330 Cham (CH)
(72) Erfinder: Felber, Armin, CH-6003 Luzern (CH)
(74) Vertreter: EGLI-EUROPEAN PATENT ATTORNEYS

(57) **Zusammenfassung**

Es wird ein Kontaktierungssystem (100) für Drahtverbindungen an elektronischen Komponenten der Halbleiter-Verbindungstechnik vorgeschlagen, welches ein Kontaktierungsorgan (30) mit daran angeordneter Kapillare (35) zur Führung eines Bonddrahtes (1) sowie mindestens eine dem Kopfstück (40) der Kapillare zugeordnete Elektrode zur Erzeugung eines Funkenübertrags umfasst, mittels welchem Funkenübertrag ein aus dem Kopfstück (40) herausstehendes Bonddraht-Endstück (1') zu einer Bonddraht-Kugel (2) geschmolzen wird.

Zur Erreichung einer gleichmässig geformten und zentrisch zu dem Bonddraht (1) beziehungsweise zum Bonddraht-Endstück (1') angeordneten Bonddraht-Kugel (2) sind mindestens zwei oder mehrere in bezug auf das Kopfstück (40) beziehungsweise auf das Bonddraht-Endstück (1') gleichmässig am Umfang verteilt angeordnete Elektroden vorgesehen, welche je mit einer eigenständigen, als Stromquelle ausgebildeten Leistungseinheit in Wirkverbindung stehen, wobei die Leistungseinheiten von einer einzigen Steuereinheit aktivierbar sind.

## Beschreibung

Die Erfindung bezieht sich auf ein Kontaktierungssystem für Drahtverbindungen an elektronischen Komponenten der Halbleiter-Verbindungstechnik, bestehend aus einem Kontaktierungsorgan mit daran angeordneter Kapillare zur Führung eines Bonddrahtes sowie einer einem Kopfstück der Kapillare feststehend oder einschwenkbar zugeordneten Elektrode zur Erzeugung eines auf ein aus dem Kopfstück herausstehendes Bonddraht-Endstück gerichteten Funkenübertrags zum Schmelzen des Bonddraht-Endstücks zu einer Bonddraht-Kugel, welche mit der jeweiligen Komponente durch Druck verschweissbar ist.

Zur Ultraschall kontaktierenden Drahtverbindung von Schaltkreisen an elektronischen Komponenten ist eine Einrichtung bekannt (US-A 4 586 642), bei welcher mittels eines um eine Achse schwenkbar gelagerten und als Energietransducer ausgebildeten Kontaktierorgans ein durch eine Kapillare geführter und mit einem Endstück aus der Kapillare geführter Bonddraht durch Funken geschmolzen und dabei zu einer Bonddraht-Kugel geformt wird, wobei beispielsweise die Bonddraht-Kugel, welche etwa dem 2,5fachen Drahtdurchmesser entspricht, auf eine Anschlussfläche (pad) eines an sich bekannten Halbleiterbauelements (semiconductor device) aufgedrückt und verschweisst (gebondet) wird.

Zur Erzeugung elektrischer Funken für die Bildung der Bonddraht-Kugel ist es bekannt, dem Kopfstück der Kapillare entweder eine in bezug auf die Kapillare einschwenkbare oder eine feststehende Elektrode zuzuordnen. Durch einen zwischen der Elektrode und dem Draht erzeugten Funkenüberschlag wird das zentrisch durch die Kapillare geführte und aus dem Kopfstück herausstehende Drahtende zu einer Kugel geschmolzen.

Bei der einschwenkbaren Elektrode wird der Funken im wesentlichen von unten auf das Bonddraht-Endstück gerichtet, wobei diese Methode einerseits einen erhöhten Zeitablauf für den Einschwenkvorgang bedingt und andererseits die erforderlichen mechanischen Mittel unter Berücksichtigung der hochdynamischen Bewegungsabläufe einem unerwünschten Verschleiss unterliegen und somit nach relativ kurzer Betriebszeit die exakte Bildung der Bonddraht-Kugel nicht mehr gewährleistet ist.

Bei der feststehenden Elektrode wird der Funken seitlich auf das Bonddraht-Endstück gerichtet, wobei diese Methode dazu führt, dass durch die Kraft des auf das Drahtende treffenden Funkens die Bonddraht-Kugel exzentrisch in bezug auf die Symmetrieachse des in der Kapillare geführten Bonddrahtes am Bonddraht-Endstück angeformt wird und somit die geforderte Bondgenauigkeit nicht eingehalten werden kann.

Der Erfindung liegt die Aufgabe zugrunde, den zum Anschmelzen der Bonddraht-Kugel erforderlichen und auf das Drahtende gerichteten Funkenübertrag dahingehend zu verbessern, dass die so angeschmolzene Bonddraht-Kugel gleichmässig geformt und zu dem in der Kapillare geführten Bonddraht zentrisch angeordnet ist.

Diese Aufgabe wird erfindungsgemäss dadurch gelöst, dass dem aus dem Kopfstück herausstehenden Bonddraht-Endstück beziehungsweise der zu bildenden Bonddraht-Kugel mindestens zwei in bezug auf das Kopfstück gleichmässig am Umfang verteilt und diametral zueinander angeordnete Elektroden zugeordnet sind, und dass jede Elektrode zur zeitlich synchronen Ansteuerung mit einer von einer einzigen Steuerheit aktivierbaren Leistungseinheit wirkverbunden ist.

Weitere Merkmale der Erfindung ergeben sich aus der folgenden Beschreibung in Verbindung mit der Zeichnung und den einzelnen Patentansprüchen.

Die Erfindung wird nachstehend anhand der Zeichnung beschrieben. Es zeigt:
- Fig.1: in perspektivischer Seitenansicht eine als Systemübersicht dargestellte Vorrichtung der Halbleiter-Verbindungstechnik,
- Fig.2: ein in grösserem Massstab und in Schnittansicht dargestelltes Teilstück einer Kapillare für das Kontaktierorgan,
- Fig.3: eine schematisch und in Draufsicht dargestellte erste Variante einer der Kapillare des Kontaktierorgans zugeordneten Elektroden-Anordnung mit als Blockschaltbild dargestelltem Stromkreis für die Elektroden, und
- Fig.4: eine zweite Variante der Elektroden-Anordnung mit entsprechend als Blockschaltbild dargestelltem Stromkreislauf.

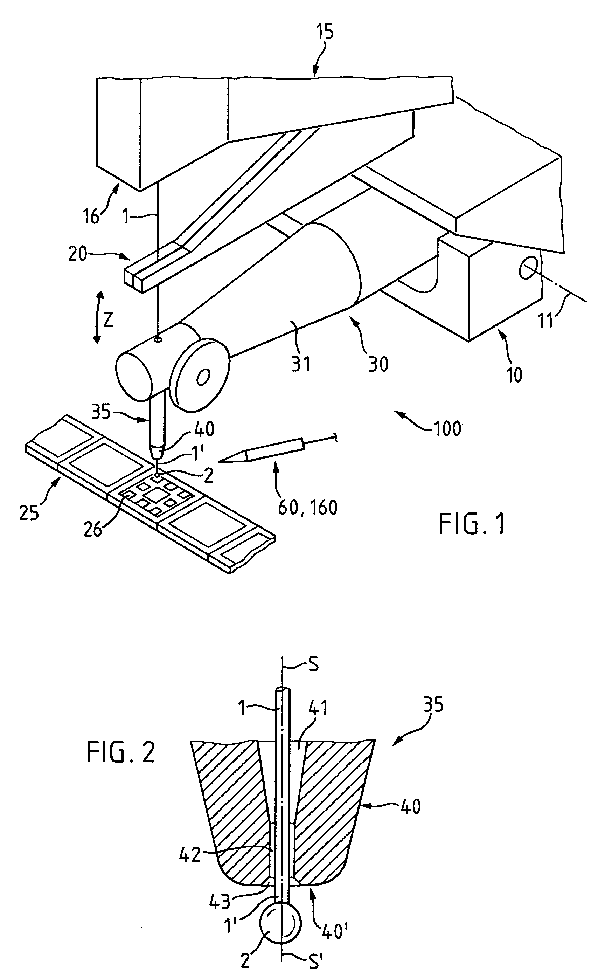

Zur Verdeutlichung der Erfindung zeigt Fig.1 in perspektivischer Seitenansicht und als allgemeine Systemübersicht eine in der Gesamtheit mit 100 bezeichnete Vorrichtung der Halbleiter-Verbindungstechnik.

Die Vorrichtung 100 umfasst im wesentlichen ein teilweise dargestelltes Trägerelement 10, einen Ausleger 15 mit daran angeordnetem optischen Abtastelement 16, eine Klemmvorrichtung 20 sowie einen mit einem Horn 31 und daran angeordneter Kapillare 35 versehenen Energietransducer 30. Der als Kontaktierorgan ausgebildete Energietransducer 30 ist mit einem nicht dargestellten Antrieb wirkverbunden und in an sich bekannter Weise um eine horizontale Achse 11 in Pfeilrichtung Z etwa oszillierend (schwingend) in dem als Gehäuse ausgebildeten Trägerelement 10 gelagert.

Die Vorrichtung 100, welche im wesentlichen die Elemente 10, 15,20,30 sowie eine in der Gesamtheit mit 60 oder 160 bezeichnete Elektroden-Anordnung umfasst, bildet eine in sich geschlossene Funktionseinheit, welche zur hochdynamischen und exakten Zustellbewegung des Energietransducers 30 mit dem Horn 31 und der daran angeordneten Kapillare 35 zu einem schematisch dargestellten und in der Gesamtheit mit 25 bezeichneten Chip (Halbleiterbauelement) ausgebildet ist.

Von einer nicht dargestellten Drahtspule wird der Klemmvorrichtung 20 ein Bonddraht 1 zugeführt, welcher von dort zentrisch in die Kapillare 35 geführt wird und ein Kopfstück 40 der Kapillare 35 derart durchdringt, dass an der Stirnseite 40' (Fig.2) des Kopfstücks 40 ein Bonddraht-Endstück 1' angeordnet ist. Das Bonddraht-Endstück 1' wird in an sich bekannter Weise durch entsprechende Funkenbildung zu einer Bonddraht-Kugel 2 verschmolzen und im wesentlichen mittels der Kapillare auf den mit entsprechenden Anschlussflächen 26 (pad) versehenen Chip 25 gedrückt und verschweisst (gebondet).

In Fig.2 ist in grösserem Massstab und in Schnittansicht das Kopfstück 40 der Kapillare 35 dargestellt. Das Kopfstück 40 wird in Richtung der Durchführung des Bonddrahtes 1 von einer ersten, konisch ausgebildeten Bohrung 41 und einer sich daran anschliessenden zweiten, zylindrisch ausgebildeten Bohrung 42 durchdrungen, wobei die Bohrung 42 an der Stirnseite 40' des Kopfstückes 40 als eine sich konisch nach aussen erweiternde Ausnehmung 43 ausgebildet ist. Weiterhin erkennt man in Fig.2 den zentrisch in dem Kopfstück 40 angeordneten Bonddraht 1 mit der angeschmolzenen Bonddraht-Kugel 2.

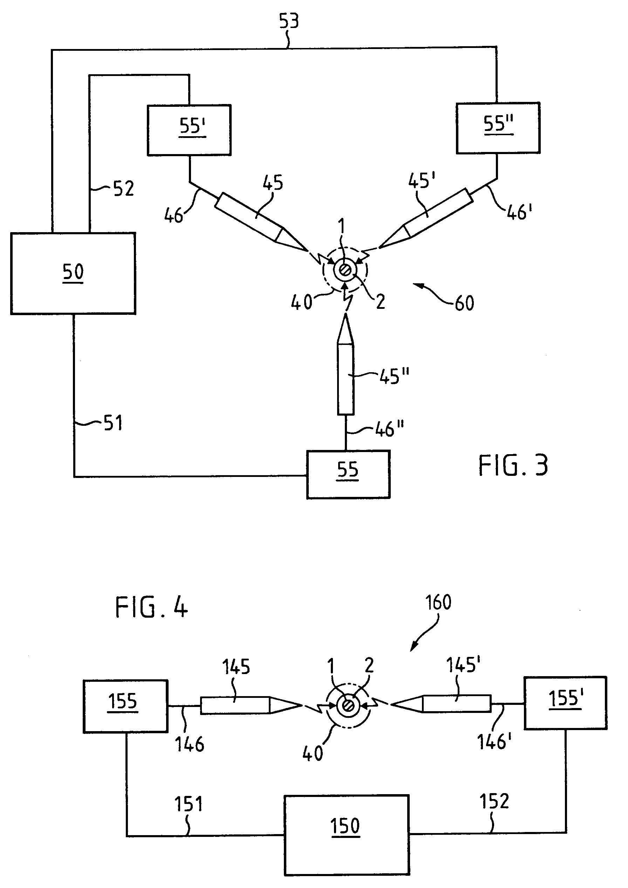

Fig.3 zeigt eine in Draufsicht und als Blockschaltbild dargestellte erste Variante einer Elektroden-Anordnung 60, und man erkennt die zur Bildung der Bonddraht-Kugel 2 (Fig.2) dem Kopfstück 40 der Kapillare 35 entsprechend zugeordneten Elektroden 45,45',45''. Zur Erzeugung der elektrischen Energie sind die Elektroden 45,45',45'' über entsprechende Leitungen 46,46',46'' jeweils mit einer zugeordneten Leistungseinheit 55,55',55'' verbunden. Die Leistungseinheiten 55,55',55'' sind über elektrische Leitungen 51,52,53 mit einer Steuereinheit 50 verbunden.

Fig.4 zeigt eine zweite Variante einer Elektroden-Anordnung 160, und man erkennt die zur Bildung der Bonddraht-Kugel 2 dem Kopfstück 40 der Kapillare 35 entsprechend zugeordneten Elektroden 145 und 145'. Zur Erzeugung der elektrischen Energie sind die beiden Elektroden 145 und 145' über entsprechende Leitungen 146 und 146' jeweils mit einer zugeordneten Leistungseinheit 155 und 155' verbunden. Die Leistungseinheiten 155 und 155' sind über elektrische Leitungen 151 und 152 mit einer Steuereinheit 150 verbunden.

Die Ansteuerung der Elektroden 45,45',45'' gemäss Fig.3 sowie die Elektroden 145 und 145' gemäss Fig.4 erfolgt vorzugsweise zeitlich synchron mit funktionell getrennten und als Stromquellen ausgebildeten Leistungseinheiten 55,55',55'' beziehungsweise 155,155'. Hierdurch wird gewährleistet, dass jede einzelne Elektrode 45,45',45'' oder 145,145' einen eigenständigen, kontrollierbaren Funken erzeugt.

Die jeweils von den Elektroden 45,45',45'' oder 145,145' auf das Bonddraht-Endstück 1' gerichtete Funkenspannung ist abhängig vom Abstand zwischen der jeweiligen Elektrode und dem Bonddraht, wobei die Funkenspannung mit dem Abstand linear ansteigt. Dieser Effekt kann zum Beispiel zur Überwachung der Zentrizität der Elektrodenanordnung und/oder zur Steuerung der Grösse der anzuschmelzenden Kugel herangezogen werden.

Bei der Überwachung der Funkenspannung wird eine Information über den Abstand zwischen der einzelnen Elektrode und dem Bonddraht ermittelt, so dass bei gleich grosser Funkenspannung der einzelnen Elektroden der Bonddraht zentrisch zu den Elektroden und bei unterschiedlicher Funkenspannung der Bonddraht exzentrisch zu den Elektroden angeordnet ist. Sofern eine exzentrische Anordnung des Bonddrahtes zu den Elektroden festgestellt wird, sind entsprechende Massnahmen zur Korrektur der Kugelsymmetrie vorzunehmen.

Zum Einstellen und Korrigieren der Kugelsymmetrie kann
- der elektrische Strom neu eingestellt werden, was beispielsweise über die einzelne Leistungseinheit 55,55',55'' beziehungsweise 155,155' oder über die Steuereinheit 50 bzw. 150 erfolgen kann, oder aber
- eine Relativ-Verstellung der Elektroden zueinander mittels mechanischer Mittel (nicht dargestellt) vorgenommen werden.

Es besteht jedoch auch die Möglichkeit, dass ein vorgegebener Wert der elektrischen Spannung mit dem momentanen Wert verglichen wird, wobei der Vergleich vorzugsweise permanent durchgeführt wird und ein daraus ermittelter Wert zur Erreichung symmetrischer Bonddraht-Kugeln herangezogen wird.

Während der auf das Bonddraht-Endstück 1' gerichteten Funkenspannungen wird eine im Durchmesser vom Bonddraht-Durchmesser abhängige Bonddraht-Kugel 2 (Fig.2) in an sich bekannter Weise angeschmolzen. Hierbei wird die Bonddraht-Kugel 2 in das Kopfstück 40 der Kapillare 35 derart zurückgeschmolzen (nicht dargestellt), dass sich der Abstand zwischen den Elektroden und der Kugel vergrössert und somit die Funkenspannung entsprechend ansteigt. Beim Erreichen des vorgegebenen elektrischen Spannungswertes wird zur Erreichung einer definierten Bonddraht-Rückschmelzlänge die Funktionseinheit der Elektroden-Anordnung 60 beziehungsweise 160 abgeschaltet.

An dieser Stelle sei darauf hingewiesen, dass dem Kopfstück 40 der Kapillare 35, wie in Fig.3 und Fig.4 dagestellt, zwei oder drei Elektroden oder aber, in nicht näher dargestellter Weise, mehrere Elektroden zugeordnet werden können. Die Elektroden sind dabei in bezug auf das Kopfstück 40 beziehungsweise in bezug auf das herausstehende Bonddraht-Endstück 1' (Fig.1,2) gleichmässig am Umfang verteilt angeordnet. Die Elektroden sind dabei in bezug auf die einzelnen Elektroden feststehend an einer entsprechend ausgebildeten, nicht dargestellten Haltevorrichtung befestigt.

Mit der symmetrischen Anordnung der einzelnen Elektroden in bezug auf das aus dem Kopfstück 40 heraustretende Bonddraht-Endstück 1' und der zeitlich synchronen Ansteuerung der Elektroden wird einerseits eine gut kontrollierbare Funkenübertragung und andererseits eine gleichmässige Formgebung der Bonddraht-Kugel 2 erreicht. Die Symmetrieachse S des Bonddrahts 1 sowie die Symmetrieachse S' der Bonddraht-Kugel 2 sind miteinander indentisch.

## Patentansprüche

1. Kontaktierungssystem für Drahtverbindungen an elektronischen Komponenten der Halbleiter-Verbindungstechnik, bestehend aus einem Kontaktierungsorgan (30) mit daran angeordneter Kapillare (35) zur Führung eines Bonddrahtes (1) sowie einer einem Kopfstück (40) der Kapillare (35) feststehend oder einschwenkbar zugeordneten Elektrode zur Erzeugung eines auf ein aus dem Kopfstück (40) herausstehenden Bonddraht-Endstück (1') gerichteten Funkenübertrags zum Schmelzen des Bonddraht-Endstücks zu einer Bonddraht-Kugel (2), welche mit der jeweiligen Komponente durch Druck verschweissbar ist, dadurch gekennzeichnet, dass dem aus dem Kopfstück (40) herausstehenden Bonddraht-Endstück (1') beziehungsweise der zu bildenden Bonddraht-Kugel (2) mindestens zwei in bezug auf das Kopfstück (40) gleichmässig am Umfang verteilt und diametral zueinander angeordnete Elektroden (145,145') zugeordnet sind, und dass jede Elektrode (145,145') zur zeitlich synchronen Ansteuerung mit einer von einer einzigen Steuerheit (150) aktivierbaren Leistungseinheit (155,155') wirkverbunden ist.

2. Kontaktierungssystem nach Anspruch 1, dadurch gekennzeichnet, dass dem Bonddraht-Endstück (1') mehrere in bezug auf das Kopfstück (40) gleichmässig am Umfang verteilte Elektroden (45,45',45'') zugeordnet sind, welche je mit einer von einer einzigen Steuereinheit (50) aktivierbaren Leistungseinheit (55,55',55'') wirkverbunden sind.

3. Kontaktierungssystem nach den Ansprüchen 1 und 2, dadurch gekennzeichnet, dass die mit den Elektroden (45,45',45'' oder 145,145') in Wirkverbindung stehenden Leistungseinheiten (55, 55',55'' oder 155,155') als elektrische Stromquellen ausgebildet sind.

4. Kontaktierungssystem nach den Ansprüchen 1 bis 3, dadurch gekennzeichnet, dass die von der jeweiligen Elektrode (45, 45',45'' oder 145,145') auf das Bonddraht-Endstück (1') gerichtete Funkenspannung zur Überwachung der Zentrizität der Elektrodenanordnung und/oder zur Erreichung symmetrischer Bonddraht-Kugeln (2) herangezogen wird, und dass zur Korrektur der Kugelsymmetrie die einzelne Leistungseinheit (55,55', 55'' oder 155,155') oder die Steuereinheit (50 oder 150) mit Mitteln zum Einstellen des elektrischen Stromes versehen ist.

5. Kontaktierungssystem nach Anspruch 4, dadurch gekennzeichnet, dass zur Korrektur der Funkenspannung die einzelnen Elektroden (45,45',45'' oder 145,145') mit mechanischen Mitteln relativ zueinander verstellbar sind.

6. Kontaktierungssystem nach Anspruch 4, dadurch gekennzeichnet, dass die einzelne Leistungseinheit (55,55',55'' oder 155,155') oder die Steuereinheit (50 oder 150) mit Mitteln zum permanenten Vergleich des vorgegebenen elektrischen Spannungswertes mit dem momentanen Wert der elektrischen Spannung versehen ist.

7. Kontaktierungssystem nach Anspruch 4 und 5, dadurch gekennzeichnet, dass die einzelne Leistungseinheit (55,55',55'' oder 155,155') mit den zugeordneten Elektroden (45,45',45'' oder 145,145') jeweils als eine Funktionseinheit (60 oder 160) ausgebildet und mit Mitteln versehen ist, mit welchen beim Erreichen des vorgegebenen elektrischen Spannungswertes die Funktionseinheit abschaltbar ist.
